(19) 

Europäisches
Patentamt
European
Patent Office
Office européen
des brevets

(11) **EP 1 844 941 A1**

(12) **EUROPEAN PATENT APPLICATION**

(43) Date of publication:
**17.10.2007 Bulletin 2007/42**

(51) Int Cl.:
*B41J 2/45* $^{(2006.01)}$       *G06K 15/12* $^{(2006.01)}$
*H01S 5/42* $^{(2006.01)}$

(21) Application number: **06125951.1**

(22) Date of filing: **12.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **12.04.2006 KR 20060033212**

(71) Applicant: **Samsung Electronics Co., Ltd.**
**Yeongtong-gu**
**Suwon-city, Gyeonggi-do 442-742 (KR)**

(72) Inventor: **Kim, Hyung-soo**
**Yeongtong-su, Suwon-si, Gyeonggi-do (KR)**

(74) Representative: **Brandon, Paul Laurence**
**APPLEYARD LEES**
**15 Clare Road**
**Halifax HX1 2HY (GB)**

(54) **Two-dimensional surface emitting laser array, multi-beam scanning unit employing the same, and image forming apparatus employing the multi-beam scanning unit**

(57)       A two-dimensional surface emitting laser array (10) having two sub-scanning pitches is provided. A multi-beam scanning unit employs the two-dimensional surface emitting laser array, and an image forming apparatus employs the multi-beam scanning unit. The two-dimensional surface emitting laser array includes n x m surface emitting lasers (15) including n surface emitting lasers arranged with substantially equal spacing a on base lines N, and m surface emitting lasers arranged with substantially equal spacing b on n inclined lines M that are inclined at an angle θ with respect to the base lines N and pass through the respective n surface emitting lasers. A plurality of first scan lines spaced apart by a first sub-scanning pitch $P_1$ or a plurality of second scan lines spaced by a second sub-scanning pitch $P_2$ whose width is different from that of the first sub-scanning pitch $P_1$ are selectively formed. the variables a, b, φ, and θ satisfy

$$\cos\phi = \frac{P_2}{P_1}$$

$$\cot\theta = \frac{\tan\phi}{2}$$

$$a = m \times P_1$$

$$b = \frac{P_1}{\cos\theta}$$

where n and m are positive integers greater than 2, and φ is an angle between a first scan line and a second scan line.

FIG. 4

**Description**

The present invention relates to two-dimensional surface emitting laser arrays, multi-beam scanning units employing the same, and image forming apparatus employing the multi-beam scanning unit.

Since multi-beam scanning units simultaneously scan a plurality of scan lines using a light source array that can emit a plurality of laser beams, the multi-beam scanning units can provide equal or higher scanning performance while reducing the driving speed of a beam deflector, for example, the number of rotations of a rotating polygonal mirror, compared to single-beam scanning units that use a single beam. Accordingly, the multi-beam scanning units can make high speed and high resolution printing possible and ensure low noise and high reliability due to the reduction in the driving speed of the beam deflector. Accordingly, the multi-beam scanning units are applied to image forming apparatuses such as laser printers, digital copiers, and facsimiles.

In multi-beam scanning units that emit a plurality of laser beams using a plurality of independently controllable light sources, the distance between adjacent light sources needs to be reduced to reduce the distance between scan lines formed on a photosensitive medium.

One-dimensional laser arrays may have a problem of interference between light sources due to the distance between the light sources being small. The interference may cause the laser power on the image-forming surface of the photosensitive medium to be greater or less than a predetermined value, thereby resulting in inconsistent print image density and print quality degradation, such as image blurring.

To solve this problem associated with one-dimensional laser arrays, U.S. Patent No. 5,848,087, the entire disclosure of which is hereby incorporated by reference, discloses a two-dimensional surface emitting laser array in which a plurality of lasers are arranged at constant intervals on a two-dimensional plane.

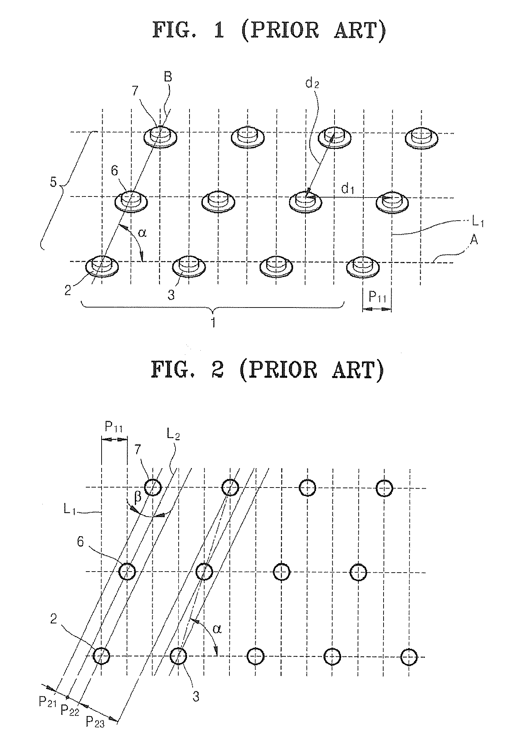

FIG. 1 is a perspective view of a conventional two-dimensional surface emitting laser array. Referring to FIG. 1, the conventional two-dimensional surface emitting laser array includes a plurality of lasers 1 that are arranged with a spacing $d_1$ on base lines A, and a plurality of lasers 5 that are arranged with a spacing $d_2$ on inclined lines B that are inclined at an angle $\alpha$ with respect to the base lines A and pass through the lasers 1. The conventional two-dimensional surface emitting laser array of FIG. 1 includes 12 lasers arranged in a 4 x 3 configuration. Two scan lines $L_1$ are formed by third and fourth lasers 6 and 7, which are respectively located at second and third lines, between scan lines $L_1$ formed by first and second lasers 2 and 3, which are adjacent to each other on a base line A. Accordingly, 12 scan lines are equally spaced by a sub-scanning pitch $P_{11}$. Compared to a one-dimensional laser array, the two-dimensional laser array can reduce the sub-scanning pitch while widening the distance between adjacent lasers, thereby avoiding interference between the adjacent lasers.

When the two-dimensional surface emitting laser array is employed as a light source of a multi-beam scanning unit and is rotated by an arbitrary angle $\beta$ as shown in FIG. 2, the sub-scanning pitch is varied. That is, when the two-dimensional surface emitting laser array configured to form the scan lines $L_1$ as shown in FIG. 1 is rotated by the angle $\beta$ to form scan lines $L_2$ as shown in FIG. 2, the adjacent first and third lasers 2 and 6 are spaced by a sub-scanning pitch $P_{22}$, the adjacent third and fourth lasers 6 and 7 are spaced by a sub-scanning pitch $P_{21}$, and the adjacent first and second lasers 2 and 3 are spaced by a sub-scanning pitch $P_{23}$. Referring to FIG. 2, the sub-scanning pitches $P_{21}$ and $P_{22}$ are equal to each other, whereas the sub-scanning pitch $P_{23}$ is different from each of the sub-scanning pitches $P_{21}$ and $P_{22}$.

Accordingly, a two-dimensional surface emitting laser array does not permit light sources to have different sub-scanning pitches. That is, the conventional two-dimensional surface emitting laser array fails to form both scan lines equally spaced by a sub-scanning pitch $P_{11}$, as shown in FIG. 1, and scan lines spaced by a sub-scanning pitch greater or less than the sub-scanning pitch $P_{11}$. Thus the conventional two-dimensional surface emitting laser array cannot be commonly employed by image forming apparatuses having different resolutions.

Accordingly, a need exists for an image forming apparatus having a multi-beam scanning unit including an improved two-dimensional surface emitting laser array that forms two types of scan lines spaced apart by different sub-scanning pitches.

The exemplary embodiments of the present invention aim to provide a two-dimensional surface emitting laser array that forms two types of scan lines spaced apart by different sub-scanning pitches, a multi-beam scanning unit employing the two-dimensional surface emitting laser array, and an image forming apparatus employing the multi-beam scanning unit.

According to an aspect of the present invention there is provided, a two-dimensional surface emitting laser array emits a plurality of laser beams at predetermined intervals in a sub-scanning direction of a photosensitive medium. The two-dimensional surface emitting laser array comprises an n x m surface emitting lasers, including n surface emitting lasers arranged with a spacing a on base lines N, and m surface emitting lasers arranged with a spacing b on n inclined lines M that are inclined at an angle $\theta$ with respect to the base lines N and pass through the respective n surface emitting lasers. A plurality of first scan lines spaced apart by a first sub-scanning pitch $P_1$ or a plurality of second scan lines spaced by a second sub-scanning pitch $P_2$ whose width is different from that of the first sub-scanning pitch $P_1$ are

selectively formed. The variables a, b, $\phi$, and $\theta$ satisfy

$$\cos\phi \ = \ \frac{P_2}{P_1}$$

$$\cot\theta \ = \ \frac{\tan\phi}{2}$$

$$a \ = \ m \times P_1$$

$$b \ = \ \frac{P_1}{\cos\theta}$$

where n and m are positive integers greater than 2, and $\phi$ is an angle between a first scan line and a second scan line.

According to another aspect of the present invention there is provided, a two-dimensional surface emitting laser array emits a plurality of laser beams at predetermined intervals in a sub-scanning direction of a photosensitive medium. The two-dimensional surface emitting laser array comprises n x 2 surface emitting lasers, including n surface emitting lasers arranged with a spacing a on base lines N, and two surface emitting lasers arranged with a spacing b on n inclined lines M that are inclined at an angle $\theta$ with respect to the base lines N and pass through the respective n surface emitting lasers. A plurality of first scan lines spaced apart by a first sub-scanning pitch $P_1$ or a plurality of second scan lines spaced by a second sub-scanning pitch $P_2$ whose widths are different from those of the first sub-scanning pitch $P_1$ are selectively formed. The variables a, b, $\phi$, and $\theta$ satisfy

$$\cos\phi \ = \ \pm\frac{P_2}{2 \times P_1}$$

$$\cot\theta \ = \ \pm\frac{\tan\phi}{(2n \pm 1)}$$

$$a \ = \ 2 \times P_1$$

$$b \ = \ \frac{P_1}{\cos\theta}$$

where n is a positive integer greater than 2, and $\phi$ is an angle between a first scan line and a second scan line.

According to another aspect of the present invention, a multi-beam scanning unit comprises a two-dimensional surface emitting laser array simultaneously emitting a plurality of laser beams at predetermined intervals in a sub-scanning direction of a photosensitive medium. A beam deflector deflects and scans the plurality of laser beams emitted by the two-dimensional surface emitting laser array in a main scanning direction of the photosensitive medium. The two-dimensional surface emitting laser array comprises n x m surface emitting lasers, including n surface emitting lasers arranged with a spacing a on base lines N, and m surface emitting lasers arranged with a spacing b on n inclined lines M that are inclined at an angle $\theta$ with respect to the base lines N and pass through the respective n surface emitting lasers. The variables a, b, $\phi$, and $\theta$ satisfy

$$\cos\phi \quad = \quad \frac{P_2}{P_1}$$

$$\cot\theta \quad = \quad \frac{\tan\phi}{2}$$

$$a \quad = \quad m \times P_1$$

$$b \quad = \quad \frac{P_1}{\cos\theta}$$

where n and m are positive integers greater than 2, and $\phi$ is an angle between a first scan line and a second scan line.

According to another aspect of the present invention, a multi-beam scanning unit comprises a two-dimensional surface emitting laser array simultaneously emitting a plurality of laser beams at predetermined intervals in a sub-scanning direction of a photosensitive medium. A beam deflector deflects and scans the plurality of laser beams emitted by the two-dimensional surface emitting laser array in a main scanning direction of the photosensitive medium. The two-dimensional surface emitting laser array comprises n x 2 surface emitting lasers, including n surface emitting lasers arranged with a spacing a on base lines N, and two surface emitting lasers arranged with a spacing b on n inclined lines M that are inclined at an angle $\theta$ with respect to the base lines N and pass through the respective n surface emitting lasers. The variables a, b, $\phi$, and $\theta$ satisfy

$$\cos\phi \quad = \quad \pm\frac{P_2}{2 \times P_1}$$

$$\cot\theta \quad = \quad \pm\frac{\tan\phi}{(2n \pm 1)}$$

$$a \quad = \quad 2 \times P_1$$

$$b \quad = \quad \frac{P_1}{\cos\theta}$$

where n is a positive integer greater than 2, and $\phi$ is an angle between a first scan line and a second scan line.

According to another aspect of the present invention, an image forming apparatus comprises a development unit having a photosensitive medium exposed to laser beams. The multi-beam scanning unit forms an electrostatic latent image by scanning laser beams onto the photosensitive medium. A transfer unit corresponds to the development unit and transfers an image developed by the development unit to the print medium. A fixing unit fixes the image transferred to the print medium.

Further features of the present invention are set out in the appended claims.

Other salient features of the invention will become apparent from the following detailed description, which, taken in conjunction with the annexed drawings, discloses exemplary embodiments of the invention.

The present invention will become more apparent by describing in detail exemplary embodiments thereof with reference to the attached drawings, in which:

FIG. 1 is a perspective view of a conventional two-dimensional surface emitting laser array;

FIG. 2 is a perspective view of a sub-scanning pitch variation when the conventional two-dimensional surface emitting laser array of FIG. 1 is rotated at an arbitrary angle $\beta$;

FIG. 3 is a perspective view of a multi-beam scanning unit according to an exemplary embodiment of the present invention;

FIG. 4 illustrates the arrangement of a two-dimensional surface emitting laser array including lasers arranged in a 4 x 2 configuration according to an exemplary embodiment of the present invention;

FIG. 5 illustrates a modification of the two-dimensional surface emitting array of FIG. 4 including lasers arranged in a 4 x 3 configuration;

FIG. 6 illustrates a two-dimensional surface emitting laser array in which the number of first scan lines is 2n+1 according to another exemplary embodiment of the present invention;

FIG. 7 illustrates a modification of the two-dimensional surface emitting laser array of FIG. 2 in which the number of first scan lines is 2n-1; and

FIG. 8 is a cross-sectional view of an image forming apparatus according to an exemplary embodiment of the present invention.

Throughout the drawings, like reference numerals will be understood to refer to like parts, components and structures.

The present invention is described more fully with reference to the accompanying drawings, in which exemplary embodiments of the invention are shown.

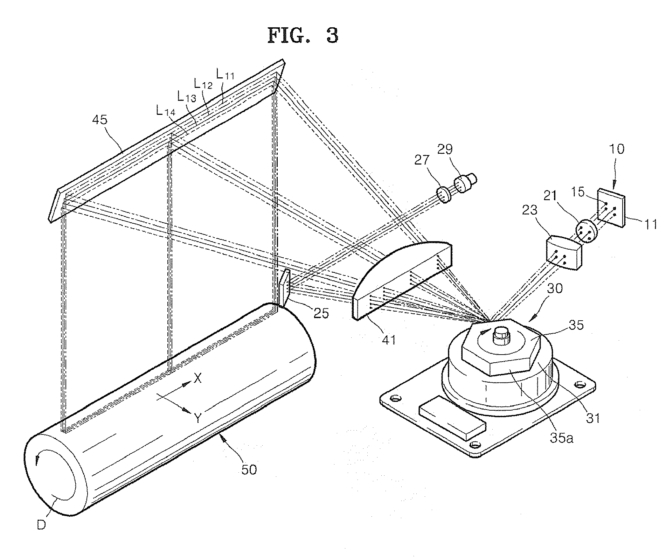

FIG. 3 is a perspective view illustrating the arrangement of a multi-beam scanning unit according to an exemplary embodiment of the present invention.

Referring to FIG. 3, the multi-beam scanning unit scans light onto a photosensitive medium 50 having an exposed surface rotated in a direction D. The multi-beam scanning unit includes a two-dimensional surface emitting laser array 10 emitting a plurality of laser beams at predetermined intervals in a sub-scanning direction Y of the photosensitive medium 50, and a beam deflector 30 deflecting and scanning the plurality of laser beams emitted by the two-dimensional surface emitting laser array 10 in a main scanning direction X of the photosensitive medium 50.

The beam deflector 30, which deflects and scans light emitted by the two-dimensional surface emitting laser array 10 in the main scanning direction X of the photosensitive medium 50, may be a polygonal mirror unit as shown in FIG. 3. The polygonal mirror unit includes a driving source 31, and a polygonal mirror 35 rotating relative to the driving source 31. The polygonal mirror 35 has a plurality of reflective side surfaces 35a, and deflects and scans incident light while rotating. The beam deflector 30 is not limited to the polygonal mirror unit, and may be a holographic disk type beam deflector, a galvanometer scanning system that deflects and scans incident beams, or any other suitable beam deflector.

A collimating lens 21 and a cylindrical lens 23 may be disposed in an optical path between the two-dimensional surface emitting laser array 10 and the beam deflector 30. The collimating lens 21 collimates or converges the plurality of beams emitted from the two-dimensional surface emitting laser array 10. The cylindrical lens 23 focuses the beam outputs through the collimating lens 21 in the main scanning direction and/or sub-scanning direction into a line on the beam deflector 30. The cylindrical lens 23 includes at least one lens.

The multi-beam scanning unit may further include an f-θ lens 41 and a synchronizing signal detecting means. The f-θ lens 41 is disposed between the beam deflector 30 and the photosensitive medium 50. The f-θ lens 41 includes at least one lens, and corrects light deflected by the beam deflector 30 at different magnifications in the main scanning direction and the sub-scanning direction so that the corrected light may be imaged on the photosensitive medium 50.

The synchronizing signal detecting means receives some of the beams emitted from the two-dimensional surface emitting laser array 10 and horizontally synchronizes scan beams. The synchronizing signal detecting means includes a synchronizing signal sensor 29 receiving some of the beams deflected by the beam deflector 30 and passing through the f-θ lens 41, a mirror 25 disposed between the f-θ lens 41 and the synchronizing signal sensor 29 and reflecting incident beams, and a focusing lens 27 focusing the beams reflected by the mirror 25.

A reflecting mirror 45 may be further disposed between the f-θ lens 41 and the photosensitive medium 50. The reflecting mirror 45 reflects scan lines incident from the beam deflector 30 to simultaneously form a plurality of scan lines, for example, four scan lines $L_{11}$, $L_{12}$, $L_{13}$, and $L_{14}$ as shown in FIG. 3, on the exposed surface of the photosensitive medium 50.

The two-dimensional surface emitting laser array 10 that emits the plurality of laser beams at predetermined intervals in the sub-scanning direction Y of the photosensitive medium 50 may selectively form one of two types of scan lines substantially equally spaced apart by different sub-scanning pitches between adjacent laser beams according to the optical arrangement.

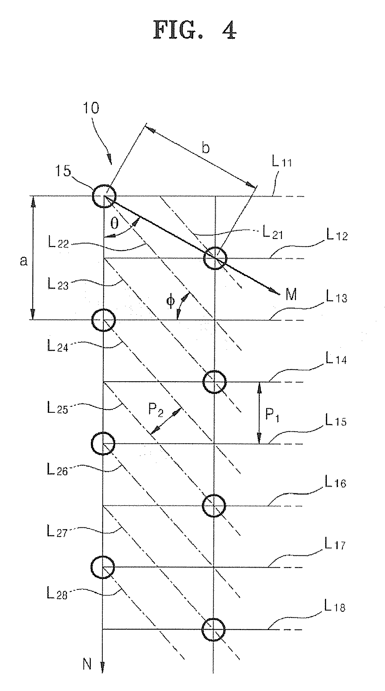

FIG. 4 illustrates the arrangement of a two-dimensional surface emitting laser array according to an exemplary embodiment of the present invention.

Referring to FIG. 4, the two-dimensional surface emitting laser array 10 includes n x m surface emitting lasers 15 including n surface emitting lasers separated from each other by an equal spacing a on base lines N, and m surface emitting lasers separated from each other by an equal spacing b on n inclined lines M that are inclined at an angle θ with respect to the base lines N and pass through the respective n surface emitting lasers. The surface emitting lasers 15 may be vertical cavity surface emitting lasers (VCSELs) that emit laser beams in a direction substantially perpendicular to a surface of substrate 11(see FIG. 3). The VCSELs may be easily arrayed on the substrate 11 in a semiconductor manufacturing process.

Referring to FIG. 4, the two-dimensional surface emitting laser array 10 includes 8 surface emitting lasers 15 arranged in a 4 x 2 configuration, where n=4 and m=2. The 8 surface emitting lasers 15 are independently driven to simultaneously emit 8 beams. The two-dimensional surface emitting laser array 10 may selectively form, using the emitted multiple beams, 8 first scan lines $L_{11}$ through $L_{18}$ equally spaced apart by a first sub-scanning pitch $P_1$ or 8 second sub scan lines $L_{21}$ through $L_{28}$ equally spaced by a second sub-scanning pitch $P_2$ having a width different from that of the first sub-scanning pitch $P_1$ according to the relationship between the two-dimensional surface emitting laser array 10 and the beam deflector 30 (see FIG. 3) in terms of their arrangement, when the variables a, b, $\phi$, and $\theta$ satisfy Equation 1.

$$\cos\phi = \frac{P_2}{P_1}$$
$$\cot\theta = \frac{\tan\phi}{2}$$
$$a = m \times P_1$$
$$b = \frac{P_1}{\cos\theta}$$

$$\dots (1)$$

where n and m are both positive integers greater than 2, and $\phi$ is an angle between a first scan line and a second scan line. That is, $\phi$ denotes the angle by which the two-dimensional surface emitting laser array 10 disposed to have the first sub-scanning pitch $P_1$ is rotated to have the second sub-scanning pitch $P_2$.

When the n x m surface emitting lasers 15 are configured to satisfy Equation 1, the two-dimensional surface emitting laser array 10 may selectively scan the plurality of first scan lines $L_{11}$ through $L_{18}$ spaced apart by the first sub-scanning pitch $P_1$ or the second scan lines $L_{21}$ through $L_{28}$ spaced by the second sub-scanning pitch $P_2$. For example, for the surface emitting lasers 15 arranged in the 4 x 2 configuration as shown in FIG. 4 to satisfy $P_1 = 14$ $\mu$m and $P_2 = 7$ $\mu$m, the variables $\phi$, $\theta$, a, and b may be calculated based on Equation 1. That is, the first sub-scanning pitch $P_1$ may be 14 $\mu$m and the second sub-scanning pitch $P_2$ may be 7 $\mu$m by arranging the plurality of surface emitting lasers 15 on the substrate 11 (see FIG. 3) so that $\phi = 60°$, $\theta = 49.11°$, a = 28 $\mu$m, and b = 21.39 $\mu$m.

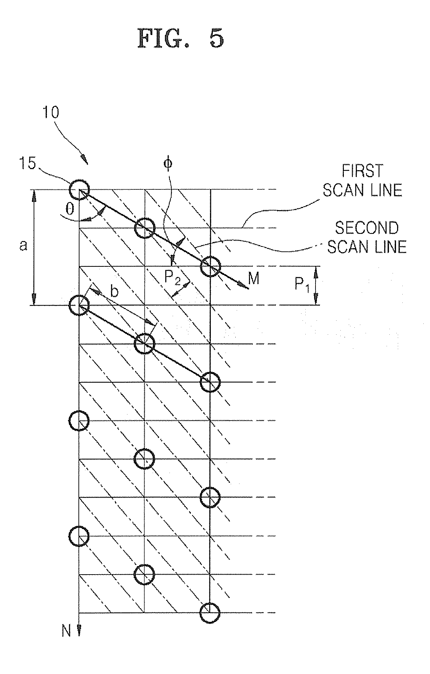

FIG. 5 illustrates a modification of the two-dimensional surface emitting laser array 10 of FIG. 4 in which the surface emitting lasers 15 are arranged in a 4 x 3 configuration. To satisfy $P_1 = 14$ $\mu$m and $P_2 = 7\mu$m, the variables $\phi$, $\theta$, a, and b may be calculated as follows. The first sub-scanning pitch $P_1$ may be 14 $\mu$m and the second sub-scanning pitch $P_2$ may be 7 $\mu$m by arranging the plurality of surface emitting lasers 15 on the substrate 11 (see FIG. 3) so that $\phi = 60°$, $\theta = 49.11°$, a = 42 $\mu$m, and b = 21.39 $\mu$m.

Accordingly, for the surface emitting lasers 15 arranged in a 4 x 4 configuration or a 4 x 5 configuration to form scan lines spaced apart by the same distance as the sub-scanning lines $P_1$ and $P_2$, $\phi$, $\theta$, and b should be respectively set to the above values, that is, 60°, 49.11 °, and 21.39 $\mu$m, and b should be set to 56 $\mu$m or 70 $\mu$m.

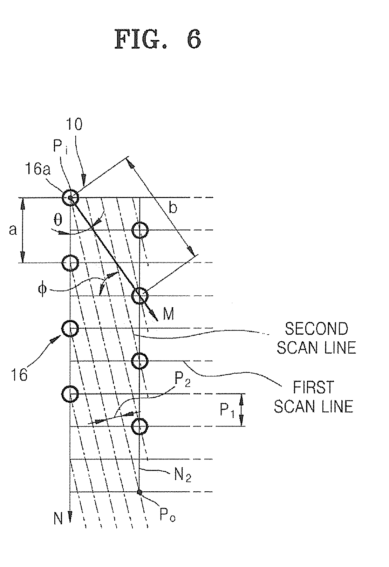

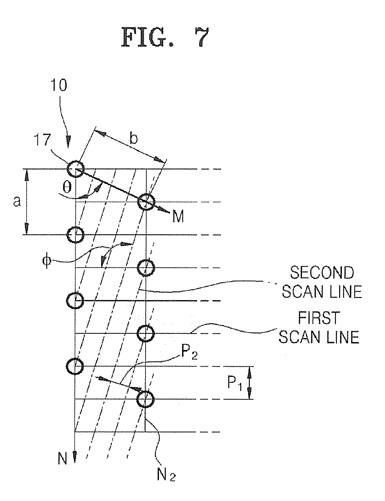

FIG. 6 illustrates the arrangement of a two-dimensional surface emitting laser array, in which the number of first scan lines is 2n+1, according to another exemplary embodiment of the present invention. FIG. 7 illustrates a modification of the two-dimensional surface emitting laser array of FIG. 6 in which the number of first scan lines is 2n-1.

Referring to FIGS. 6 and 7, the two-dimensional surface emitting laser array 10 respectively includes n x 2 surface emitting lasers 16 and 17, including n surface emitting lasers arranged with substantially equal spacing a on base lines N and two surface emitting lasers arranged with spacing b on n inclined surfaces M that are inclined at an angle $\theta$ with respect to the base lines N and pass through the respective n surface emitting lasers.

When a second scan line formed by a surface emitting laser 16a, which is located on a base line N, meets a second base line $N_2$ adjacent to the base line N, each of the (2n+1) and (2n-1) is the number of first scan lines between an intersection point $P_i$ between the second scan line and the base line N and an intersection point $P_0$ between the second scan line and the second base line $N_2$.

The two-dimensional surface emitting laser array 10 of FIG. 6 has 9 (=2x4+1) first scan lines, and the two-dimensional surface emitting laser array 10 of FIG. 7 has 7 (= 2x4-1) first scan lines.

FIG. 6 illustrates the two-dimensional surface emitting laser array 10 including 8 surface emitting lasers arranged in a 4 x 2 configuration in which the number of first scan lines is 2n+1 (n=4). The respective surface emitting lasers 16 are independently driven to simultaneously emit 8 beams. The two-dimensional surface emitting laser array 10 may selectively form, using multiple beams, 8 first scan lines substantially equally spaced apart by a first sub-scanning pitch $P_1$ or 8 second scan lines substantially equally spaced by a second sub-scanning pitch $P_2$ having a width different from that of the first sub-scanning pitch $P_1$ according to the relationship between the two-dimensional surface emitting laser array 10 and the beam deflector 30 (see FIG. 3) in terms of their arrangement, when the variables a, b, φ, and θ satisfy Equation 2.

$$\cos\phi = \frac{P_2}{2 \times P_1}$$
$$\cot\theta = \frac{\tan\phi}{(2n+1)}$$
$$a = 2 \times P_1$$
$$b = \frac{P_1}{\cos\theta}$$

$$\ldots (2)$$

where n is a positive integer greater than 2 and φ is an angle between a first scan line and a second scan line. That is, φ denotes the angle by which the two-dimensional surface emitting laser array 10 disposed to have the first sub-scanning pitch $P_1$ is rotated to have the second sub-scanning pitch $P_2$.

When the n x 2 surface emitting lasers 16 are configured to satisfy Equation 2, the two-dimensional surface emitting laser array 10 may selectively scan the plurality of first scan lines spaced by the first sub-scanning pitch $P_1$ or the second scan lines spaced apart by the second sub-scanning pitch $P_2$. For example, for the surface emitting lasers 16 arranged in the 4 x 2 configuration as shown in FIG. 6 to satisfy $P_1 = 14$ μm and $P_2 = 7$ μm, the variables φ, θ, a, and b may be calculated based on Equation 2. That is, the first sub-scanning pitch $P_1$ may be 14 μm and the second sub-scanning pitch $P_2$ may be 7 μm by arranging the plurality of surface emitting lasers 16 on the substrate 11 (see FIG. 3) so that φ = 75.52°, θ = 66.72°, a = 28 μm, and b = 35.42 μm.

FIG. 7 illustrates the two-dimensional surface emitting laser array 10 including 8 surface emitting lasers 17 arranged in the 4 x 2 configuration in which the number of first scan lines is 2n-1 (n=4). The respective surface emitting lasers 17 are independently driven to simultaneously emit 8 beams. The two-dimensional surface emitting laser array 10 may selectively form, using the emitted multiple beams, 8 first scan lines substantially equally spaced apart by a first sub-scanning pitch $P_1$ or 8 second scan lines substantially equally spaced by a second sub-scanning pitch $P_2$ having a width different from that of the first sub-scanning pitch $P_1$ according to the relationship between the two-dimensional surface emitting laser array 10 and the beam deflector 30 (see FIG. 3) in terms of their arrangement, when the variables a, b, φ, and θ satisfy Equation 3.

$$\cos\phi = -\frac{P_2}{2 \times P_1}$$
$$\cot\theta = -\frac{\tan\phi}{(2n-1)}$$
$$a = 2 \times P_1$$
$$b = \frac{P_1}{\cos\theta}$$

$$\ldots (3)$$

where n is a positive integer greater than 2 and φ is an angle between a first scan line and a second scan line. That is, φ denotes the angle at which the two-dimensional surface emitting laser array 10 disposed to have the first sub-scanning pitch $P_1$ is rotated to have the second sub-scanning pitch $P_2$.

When the n x 2 surface emitting lasers 17 are configured to satisfy Equation 3, the two-dimensional surface emitting laser array 10 may selectively scan the plurality of first scan lines spaced apart by the first sub-scanning pitch $P_1$ or the second scan lines spaced by the second sub-scanning pitch $P_2$. For example, for the surface emitting lasers 17 arranged in the 4 x 2 configuration as shown in FIG. 7 to satisfy $P_1$ = 14 $\mu$m and $P_2$ = 7 $\mu$m, the variables $\phi$, $\theta$, a, and b may be calculated based on Equation 3. That is, the first sub-scanning pitch $P_1$ may be 14 $\mu$m and the second sub-scanning pitch $P_2$ may be 7 $\mu$m by arranging the plurality of surface emitting lasers 17 on the substrate 11 (see FIG. 3) so that $\varphi$ = 104.48°, $\theta$ = 61.04°, a = 28 $\mu$m, and b = 28.92 $\mu$m.

Accordingly, by arranging the two-dimensional surface emitting laser array 10 so that a plurality of scan lines are spaced by the first or second sub-scanning pitch $P_1$ or $P_2$, the multi-beam scanning unit may have two sub-scanning magnifications or two resolutions.

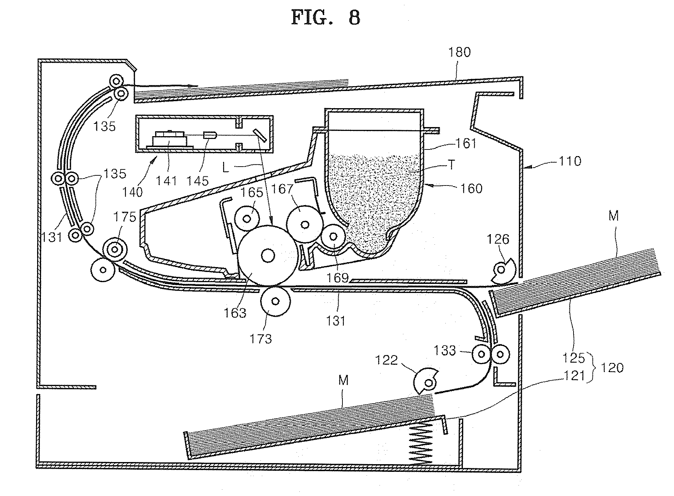

FIG. 8 is a cross-sectional view of an image forming apparatus according to an exemplary embodiment of the present invention. Referring to FIG. 8, the image forming apparatus includes a cabinet 110, a development unit 160 mounted in the cabinet 110, a multi-beam scanning unit 140 forming an electrostatic latent image, a transfer unit 173 transferring an image developed by the development unit 160 to a print medium, and a fixing unit 175 fixing the image transferred to the print medium.

The cabinet 110 defines the outer shape of the image forming apparatus, and an ejection unit 180 on which ejected print media M are stacked is disposed outside the cabinet 110. A feed unit 120 on which print media M are stacked is detachably disposed on the cabinet 110. The print media M fed by the feed unit 120 are conveyed through a print medium path 131 to the development unit 160.

The feed unit 120 includes a first feed unit 121 for automatically feeding print media M and a second feed unit 125 for manually feeding print media M. The first feed unit 121 is disposed inside the cabinet 110, and feeds print media M by the rotation of a first feeding roller 122. The second feed unit 125 is installed outside the cabinet 110, and feeds print media M to the print medium path 131 by the rotation of a second feeding roller 126.

The print medium path 131, through which the print media M are conveyed by being fed by the feed unit 120, is formed in the cabinet 110 and includes a plurality of conveying rollers 133 and 135. The print medium path 131 branches into two parts near the first and second feed units 121 and 125, and is a single path while contributing to image formation and print medium ejection.

The development unit 160 includes a toner container 161 in which a predetermined color toner T is contained, and an image forming unit receiving the toner T from the toner container 161 and forming an image.

The image forming unit includes a photosensitive medium 163 sensitive to a plurality of laser beams L scanned by the multi-beam scanning unit 140, a charger 165 charging the photosensitive medium 163 to a predetermined potential, a developing roller 167 facing the photosensitive medium 163 and developing an electrostatic latent image formed on the photosensitive medium 163 using the toner T, and a supply roller 169 supplying the toner T to the developing roller 167.

The multi-beam scanning unit 140 scans light to the photosensitive medium 163 to form an electrostatic latent image on the photosensitive medium 163. The scanning unit 140 includes the two-dimensional surface emitting laser array 10 (see FIG. 3) that substantially simultaneously emits a plurality of laser beams at predetermined intervals in a sub-scanning direction of the photosensitive medium 163, a beam deflector 141 that deflects and scans the plurality of laser beams emitted by the two-dimensional surface emitting laser array 10 in a main scanning direction of the photosensitive medium 163, and an f-$\theta$ lens 145. The structure and principle of the multi-beam scanning unit 140 is substantially similar to that of the multi-beam scanning unit of FIG. 3, and a detailed explanation thereof is omitted.

The transfer unit 173 faces the photosensitive medium 163 with a print medium conveyed through the print medium path 131 therebetween. The transfer unit 173 transfers the image formed on the photosensitive medium 163 to the print medium. The image transferred to the print medium by the transfer unit 173 is fixed by the fixing unit 175.

As described above, the two-dimensional surface emitting laser array of the exemplary embodiments of the present invention may configure the light sources to have two sub-scanning pitches with different widths. Accordingly, the two-dimensional surface emitting laser array may be applied to optical systems having two sub-scanning magnifications or two resolutions by changing the rotation angle of the two-dimensional surface emitting laser array.

Also, the multi-beam scanning unit of the exemplary embodiments of the present invention may be commonly used by an image forming apparatus having different resolutions by employing the two-dimensional surface emitting laser array as a light source and selectively forming one of two types of scan lines substantially equally spaced apart by different sub-scanning pitches between laser beams according to the optical arrangement.

Furthermore, the image forming apparatus employing the multi-beam scanning unit of the exemplary embodiments of the present invention may reduce manufacturing costs because the multi-beam scanning unit may be commonly used for image forming apparatus having different resolutions. Also, the image forming apparatus may change the resolution by altering the arrangement of the multi-beam scanning unit without replacing the multi-beam scanning unit.

While the present invention has been particularly shown and described with reference to exemplary embodiments thereof, it will be understood by those of ordinary skill in the art that various changes in form and details may be made therein without departing from the spirit and scope of the present invention as defined by the following claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1.  A two-dimensional surface emitting laser array (10) emitting a plurality of laser beams at predetermined intervals in a sub-scanning direction of a photosensitive medium, the two-dimensional surface emitting laser array comprising:

    n x m surface emitting lasers (15) including n surface emitting lasers arranged with substantially equal spacing a on base lines N and m surface emitting lasers arranged with substantially equal spacing b on n inclined lines M that are inclined at an angle θ with respect to the base lines N and pass through the respective n surface emitting lasers,
    wherein, to selectively form a plurality of first scan lines spaced apart by a first sub-scanning pitch $P_1$ or a plurality of second scan lines spaced by a second sub-scanning pitch $P_2$ whose width is different from that of the first sub-scanning pitch $P_1$, the variables a, b, $\phi$, and θ satisfy

    $$\cos\phi \;=\; \frac{P_2}{P_1}$$

    $$\cot\theta \;=\; \frac{\tan\phi}{2}$$

    $$a \;=\; m \times P_1$$

    $$b \;=\; \frac{P_1}{\cos\theta}$$

    where n and m are positive integers greater than 2, and $\phi$ is an angle between a first scan line and a second scan line.

2.  The two-dimensional surface emitting laser array (10) of claim 1, wherein the surface emitting lasers (15) are vertical cavity surface emitting lasers (VCSELs).

3.  A two-dimensional surface emitting laser array (10) emitting a plurality of laser beams at predetermined intervals in a sub-scanning direction of a photosensitive medium, the two-dimensional surface emitting laser array comprising:

    n x 2 surface emitting lasers (16a, 17) including n surface emitting lasers arranged with substantially equal spacing a on base lines N and two surface emitting lasers arranged with substantially equal spacing b on n inclined lines M that are inclined at an angle θ with respect to the base lines N and pass through the respective n surface emitting lasers,
    wherein, to selectively form a plurality of first scan lines spaced apart by a first sub-scanning pitch $P_1$ or a plurality of second scan lines spaced by a second sub-scanning pitch $P_2$ whose widths are different from those of the first sub-scanning pitch $P_1$, the variable a, b, $\phi$, and $\theta$ satisfy

$$\cos\phi \;=\; \pm\frac{P_2}{2\times P_1}$$

$$\cot\theta \;=\; \pm\frac{\tan\phi}{(2n\pm 1)}$$

$$a \;=\; 2\times P_1$$

$$b \;=\; \frac{P_1}{\cos\theta}$$

where n is a positive integer greater than 2, and $\phi$ is an angle between a first scan line and a second scan line.

4. The two-dimensional surface emitting laser (10) array of claim 3, wherein the surface emitting lasers (16a, 17) are VCSELs.

5. A multi-beam scanning unit, comprising:

a two-dimensional surface emitting laser array (10) simultaneously emitting a plurality of laser beams at predetermined intervals in a sub-scanning direction of a photosensitive medium (50); and
a beam deflector (30) deflecting and scanning the plurality of laser beams emitted by the two-dimensional surface emitting laser array in a main scanning direction of the photosensitive medium,
wherein the two-dimensional surface emitting laser array comprises n x m surface emitting lasers (15) including n surface emitting lasers arranged with an equal spacing a on base lines N and m surface emitting lasers arranged with an equal spacing b on n inclined lines M that are inclined at an angle $\theta$ with respect to the base lines N and pass through the respective n surface emitting lasers, and the variables a, b, $\phi$, and $\theta$ satisfy

$$\cos\phi \;=\; \frac{P_2}{P_1}$$

$$\cot\theta \;=\; \frac{\tan\phi}{2}$$

$$a \;=\; m\times P_1$$

$$b \;=\; \frac{P_1}{\cos\theta}$$

where n and m are positive integers greater than 2, and $\phi$ is an angle between a first scan line and a second scan line.

6. The multi-beam scanning unit of claim 5, wherein the surface emitting lasers (15) are vertical cavity surface emitting lasers (VCSELs).

**7.** A multi-beam scanning unit, comprising:

a two-dimensional surface emitting laser array (10) substantially simultaneously emitting a plurality of laser beams at predetermined intervals in a sub-scanning direction of a photosensitive medium (50); and
a beam deflector (30) deflecting and scanning the plurality of laser beams emitted by the two-dimensional surface emitting laser array in a main scanning direction of the photosensitive medium,
wherein the two-dimensional surface emitting laser array comprises n x 2 surface emitting lasers (16a, 17) including n surface emitting lasers arranged with substantially equal spacing a on base lines N and two surface emitting lasers arranged with substantially equal spacing b on n inclined lines M that are inclined at an angle θ with respect to the base lines N and pass through the respective n surface emitting lasers, and the variables a, b, ϕ, and θ satisfy

$$\cos\phi \;=\; \pm\frac{P_2}{2\times P_1}$$

$$\cot\theta \;=\; \pm\frac{\tan\phi}{(2n\pm1)}$$

$$a \;=\; 2\times P_1$$

$$b \;=\; \frac{P_1}{\cos\theta}$$

where n is a positive integer greater than 2, and ϕ is an angle between a first scan line and a second scan line.

**8.** The multi-beam scanning unit of claim 7, wherein the surface emitting lasers (16a, 17) are vertical cavity surface emitting lasers (VCSELs).

**9.** An image forming apparatus, comprising:

a development unit (160) having a photosensitive medium (163) exposed to laser beams;
a multi-beam scanning unit (140) forming an electrostatic latent image by scanning laser beams onto the photosensitive medium;
a transfer unit (173) corresponding to the development unit and transferring an image developed by the development unit to a print medium (M); and
a fixing unit (175) fixing the image transferred to the print medium;
wherein the multi-beam scanning unit includes a two-dimensional surface emitting laser array (10) simultaneously emitting a plurality of laser beams at predetermined intervals in a sub-scanning direction of a photosensitive medium; and
a beam deflector (141) deflecting and scanning the plurality of laser beams emitted by the two-dimensional surface emitting laser array in a main scanning direction of the photosensitive medium,
wherein the two-dimensional surface emitting laser array comprises n x m surface emitting lasers (15) including n surface emitting lasers arranged with an equal spacing a on base lines N and m surface emitting lasers arranged with an equal spacing b on n inclined lines M that are inclined at an angle θ with respect to the base lines N and pass through the respective n surface emitting lasers, and the variables a, b, ϕ, and θ satisfy

$$\cos\phi \;=\; \frac{P_2}{P_1}$$

$$\cot\theta \quad = \quad \frac{\tan\phi}{2}$$

$$a \quad = \quad m \times P_1$$

$$b \quad = \quad \frac{P_1}{\cos\theta}$$

where each of n and m is a positive integer greater than 2, and $\phi$ is an angle between a first scan line and a second scan line.

10. The multi-beam scanning unit of claim 9, wherein the surface emitting lasers (15) are vertical cavity surface emitting lasers (VCSELs).

11. An image forming apparatus, comprising:

a development unit (160) having a photosensitive medium (163) exposed to laser beams;
a multi-beam scanning unit (140) forming an electrostatic latent image by scanning laser beams onto the photosensitive medium;
a transfer unit (173) corresponding to the development unit and transferring an image developed by the development unit to a print medium (M); and
a fixing unit (175) fixing the image transferred to the print medium;
wherein the multi-beam scanning unit includes a two-dimensional surface emitting laser array (10) substantially simultaneously emitting a plurality of laser beams at predetermined intervals in a sub-scanning direction of a photosensitive medium; and
a beam deflector (141) deflecting and scanning the plurality of laser beams emitted by the two-dimensional surface emitting laser array in a main scanning direction of the photosensitive medium,
wherein the two-dimensional surface emitting laser array comprises n x 2 surface emitting lasers (16a, 17) including n surface emitting lasers arranged with substantially equal spacing a on base lines N and two surface emitting lasers arranged with substantially equal spacing b on n inclined lines M that are inclined at an angle $\theta$ with respect to the base lines N and pass through the respective n surface emitting lasers, and the variables a, b, $\phi$, and $\theta$ satisfy

$$\cos\phi \quad = \quad \pm\frac{P_2}{2 \times P_1}$$

$$\cot\theta \quad = \quad \pm\frac{\tan\phi}{(2n \pm 1)}$$

$$a \quad = \quad 2 \times P_1$$

$$b \quad = \quad \frac{P_1}{\cos\theta}$$

where n is a positive integer greater than 2, and $\phi$ is an angle between a first scan line and a second scan line.

12. The multi-beam scanning unit of claim 11, wherein the surface emitting lasers (16a, 17) are vertical cavity surface emitting lasers (VCSELs).

# FIG. 1 (PRIOR ART)

# FIG. 2 (PRIOR ART)

# FIG. 3

# FIG. 4

FIG. 5

# FIG. 6

# FIG. 7

FIG. 8

**European Patent Office**

**EUROPEAN SEARCH REPORT**

Application Number

EP 06 12 5951

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 808 656 A (GOLDMANN GERD [DE]) 15 September 1998 (1998-09-15) * abstract; figures 1-9 * * column 3, lines 25-27 * * column 4, lines 40-53 * * column 5, lines 40-45 * ----- | 1-12 | INV. B41J2/45 G06K15/12 ADD. H01S5/42 |
| A | US 2004/090657 A1 (FUKUDA TAKESHI [JP] ET AL) 13 May 2004 (2004-05-13) * abstract; figures 1-9 * * paragraphs [0031], [0032], [0075] - [0079] * ----- | 1-12 | |
| A | EP 1 134 996 A (MOTOROLA INC [US]) 19 September 2001 (2001-09-19) * abstract; figures 1,2 * * paragraph [0032] * ----- | 1-12 | |

TECHNICAL FIELDS SEARCHED (IPC)

B41J
G06K
H01S

The present search report has been drawn up for all claims

| Place of search | Date of completion of the search | Examiner |
|---|---|---|
| Munich | 27 July 2007 | Marani, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 12 5951

This annex lists the patent family members relating to the patent documents cited in the above-mentioned European search report.
The members are as contained in the European Patent Office EDP file on
The European Patent Office is in no way liable for these particulars which are merely given for the purpose of information.

27-07-2007

| Patent document cited in search report | | Publication date | Patent family member(s) | | Publication date |
|---|---|---|---|---|---|
| US 5808656 | A | 15-09-1998 | WO<br>EP | 9508160 A1<br>0719434 A1 | 23-03-1995<br>03-07-1996 |
| US 2004090657 | A1 | 13-05-2004 | NONE | | |
| EP 1134996 | A | 19-09-2001 | US | 2001022791 A1 | 20-09-2001 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5848087 A